# EUROPEAN PATENT APPLICATION

(11) **EP 0 829 933 A2**
(43) Date of publication of application: **18.03.1998**
(21) Application number: 97307144.2
(22) Date of filing: 15.09.1997
(51) Int. Cl.: H01S 3/085, G06K 15/12

(54) **VCSEL integral feedback assembly**

(30) Priority: 16.09.1996 US 715260
(71) Applicant: XEROX CORPORATION, Rochester New York 14644 (US)
(72) Inventor: Guerin, Jean-Michel, Glendale, California 91206 (US)
(74) Representative: Mackett, Margaret Dawn

(57) **Abstract**

There is disclosed a raster output scanner (40) which utilizes a vertical cavity laser diode (VCSEL) assembly (42) with an integral set of detectors (S₁, ..., S₅) for the purpose of individually monitoring and adjusting the output power each laser diode (ℓ₁, ..., ℓ₅). A semi-transparent and semi-reflective plate (70) is positioned to allow a portion of each light beam (ℓ₁, ..., ℓ₅) to pass through and reflects the remaining portion of each light beam (ℓ'₁, ..., ℓ'₅) back onto the detectors (S₁, ..., S₅) of the VCSEL assembly (42) to provide a feedback to adjust the output power of its respective laser diode(ℓ₁, ..., ℓ₅).

## Description

This invention relates to a feedback system for a set of Vertical Cavity Laser Diode (VCSEL) assembly, and more particularly, to a design of a raster output scanner which utilizes a VCSEL assembly with an integral feedback system for monitoring the output power of each individual diode of the set of VCSELs.

Typically, a single beam laser diode assembly has a single diode and usually, in a scanning system, the diode is connected to a train of image pixel information. The pixel information is used to drive the diode and therefore stimulate laser flux emission where there is a pixel. Ideally, in order to keep the light beam generated by the laser diode constant, the temperature of the diode should be kept at a constant level. However, due to the changing duty cycle of the train of image pixel information and also due to the environmental temperature variations, over time, the temperature of the diode increases which in turn causes the output power of the laser diode to decrease. The decrease in the output power will cause a decrease in the amount of discharge on the photoreceptor. This in turn will cause a decrease in the amount of toner attraction on the photoreceptor which will cause the shade of the image of a printed document to deviate from an intended shade.

In order to eliminate the deviation of the shade of the image, it is necessary to keep the output level of a laser diode at a certain level. It should be noted that in this specification, "image" shall mean both text and graphics.

In a set of laser diodes assembly, there are multiple laser diodes each of which emits a single light beam and each light beam is modulated individually with a different train of pixel information. Multi-laser diodes are usually used in raster scanning systems to scan multiple lines simultaneously in an interlace format.

Once light beams are used in an interlace format, if the output power of one light beam slightly differs from the other light beam, a phenomenon known as banding will appear on the printed document. In banding, the scan lines which are scanned by one light beam will be either darker or lighter than the scan lines which are scanned by the other light beam.

It is extremely important to keep the output power of all the laser diodes at a certain level to eliminate the banding problem. However, due to the tolerances of laser diodes, each laser diode reacts differently to the temperature and its output power changes differently based on the temperature change. As a result, each laser diode exposes the photoreceptor differently which creates the banding problem.

Since the banding problem is created as a result of difference between the output power of the diodes, it is necessary to adjust the output power of each laser diode individually.

It is an object of this invention to individually adjust the output power of each laser diode of a VCSEL set in order to sufficiently reduce the banding problem.

According to the present invention, there is provided a raster output scanner comprising: a member having a plurality of lasing diodes for emitting a plurality of light beams and a plurality of light detecting means each of which corresponds to one of said plurality of lasing diodes; collimating means located in the path of said plurality of light beams for collimating said light beams; a medium; and scanning means located in the path of said light beams from said collimating means for scanning said light beams across said medium; characterized in that the scanner further comprises semi-transparent and semi-reflective means located between said collimating means and said scanning means for receiving said light beams and partially passing said light beams onto said scanning means and partially reflecting each of said light beams back onto one of said light detecting means through said collimating means.

In accordance with the present invention, there is disclosed a raster output scanner which utilizes a set of vertical cavity laser diode (VCSEL) assembly with a plurality of integral light detectors. The raster output scanner of this invention, also utilizes a semi transparent and semi-reflective plate to pass through a portion of each light beam and reflect the remaining portion of each light beam onto each detector. Each detector has an electrical connection to a corresponding one of the laser diodes of the VCSELs to provide a feedback for the purpose of individually adjusting the output power of its respective laser diode.

For a better understanding of the present invention, reference will now be made, by way of example only, to the accompanying drawings in which:-
Figure 1 shows a tangential (fast-scan) view of a prior art raster scanning system;
Figure 2 shows a sagittal (cross-scan) view of the raster scanning system of Figure 1;
Figure 3 shows a raster scanning system in accordance with the present invention which is capable of monitoring the output power of each individual laser diode;
Figure 4 shows a magnified cross sectional view of the VCSEL light source of Figure 3;
Figure 5 shows a magnified top view of Figure 4;
Figure 6 shows a magnified cross sectional view of the plate 62 of Figure 4 along line A-A;
Figure 7 shows a magnified portion of Figure 3 in which only the path of the light beam from the laser diode d₁ and the path of the same light beam after it is reflected are shown;
Figure 8 shows a magnified portion of Figure 3 in which only the path of the light beam from the laser diode d₅ and the path of the same light beam after it is reflected are shown; and
Figure 9 shows a top view of a two dimensional array of the VCSEL integral feedback assembly in accordance with the present invention.

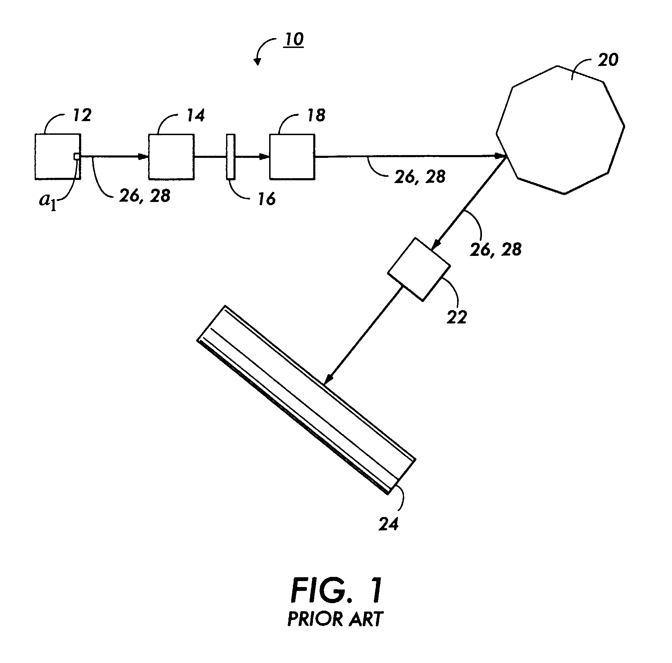

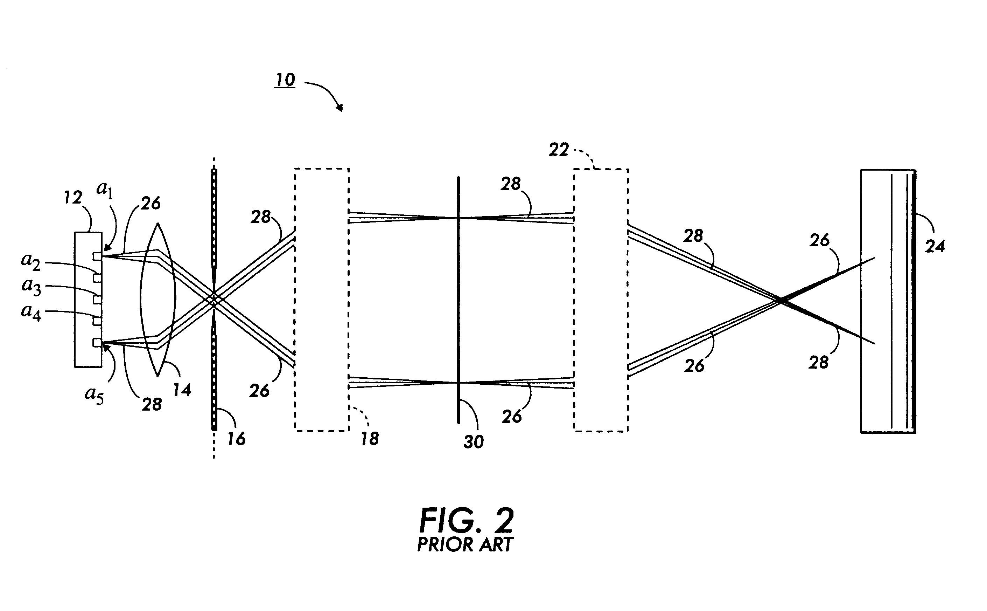

Referring to Figure 1, there is shown a tangential (fast-scan) view of a prior art multi-beam raster scanning system 10 and referring to Figure 2, there is shown a sagittal (cross-scan) view of the raster scanning system 10 of Figure 1. Referring to both Figures 1 and 2, raster scanning system 10 utilizes a multi-beam laser light source 12, a collimator 14, an aperture 16, pre-polygon optics 18, a multi-faceted rotating polygon mirror 20 as the scanning element, post polygon optics 22 and a photosensitive medium 24.

The laser light source 12 has multiple laser diodes a_{1,} a₂, a₃, a₄ and a₅. However, for the purpose of simplicity only the light beams from the laser diodes a₁ and a₅ are shown. Laser diode a₁ emits a light beam 26 and laser diode a₅ emits a light beam 28.

The rotating polygon mirror has a plurality of facets, each of which is a plane mirror. However in Figure 2, for the purpose of simplicity, one of the facets 30 which is receiving the light beams, at a given time, is shown as line 30 and the light beams reflected by the facet 30 are unfolded.

The laser light source 12 sends the light beams 26 and 28 to the rotating polygon mirror 20 through the collimator 14, the aperture 16 and the pre-polygon optics 18. The collimator 14 collimates the light beams 26 and 28. The aperture 16 clips the light beams 26 and 28 as needed and the pre-polygon optics 18 focuses the light beams 26 and 28 in the sagittal or cross-scan plane onto the rotating polygon mirror 20.

The facets of the rotating polygon mirror 20 reflect the light beams 26 and 28 and also cause the reflected light beams 26 and 28 to revolve about an axis near the reflection point of the facet. The reflected light beams 26 and 28 can be utilized through the post polygon optics 22 to scan a document at the input end of an imaging system as a raster input scanner or can be used to impinge upon a photographic film or a photosensitive medium 24, such as a xerographic drum (photoreceptor), at the output of the imaging system.

The rotating polygon mirror 20 scans both light beams 26 and 28 across the photoreceptor 24 simultaneously in an interlace format. The light beams 26 and 28 start scanning the photoreceptor simultaneously with each light beam scanning an individual line.

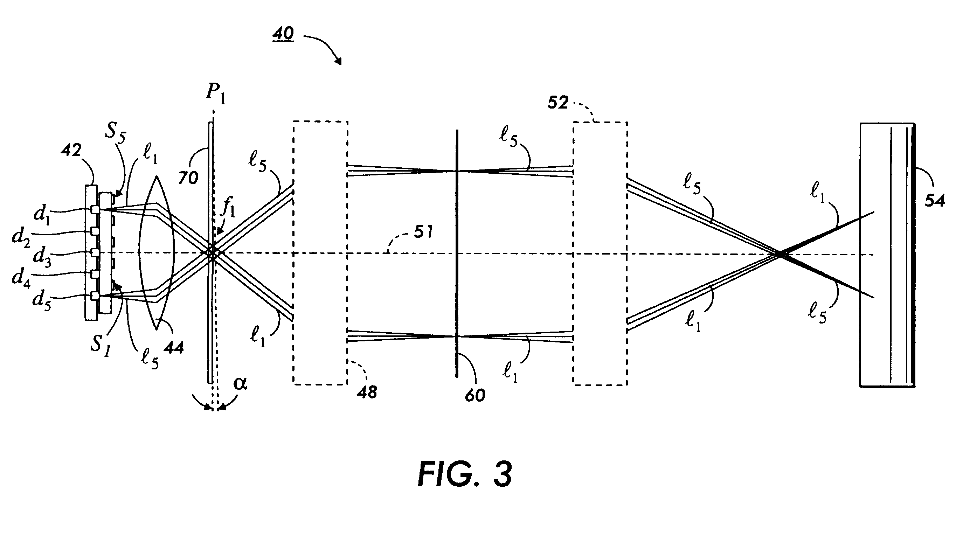

Referring to Figure 3, there is shown a raster scanning system 40 in accordance with the present invention which is capable of monitoring the output power of each individual laser diode. In Figure 3, the optical elements 44, 48, 60, 52 and 54 are the same and serve the same purpose as the optical elements 14, 18, 30, 22 and 24 respectively of Figure 2. The raster scanning system 40 utilizes a VCSEL light source 42.

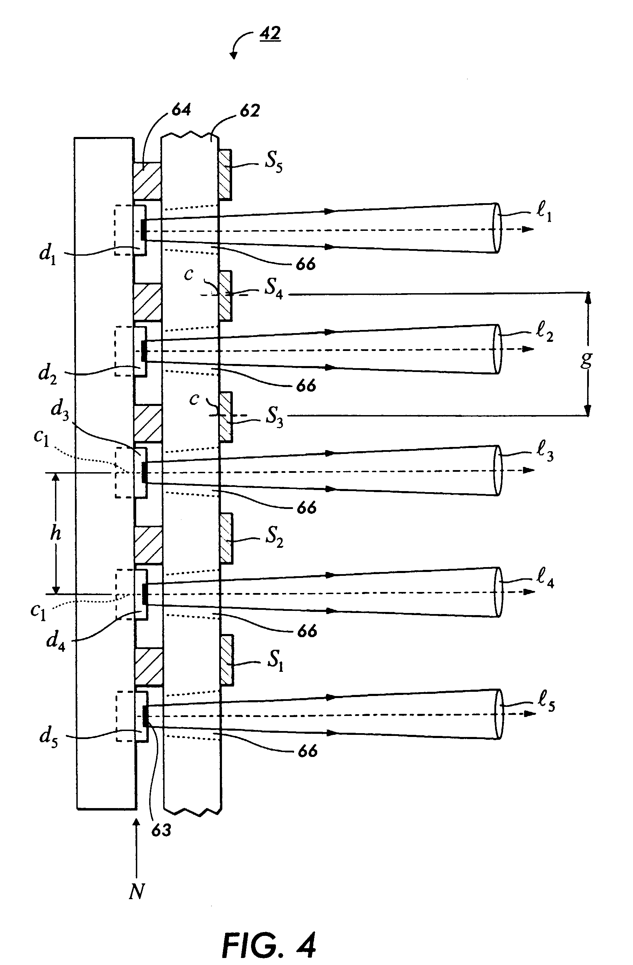

Referring to Figure 4, there is shown a magnified cross sectional view of the VCSEL light source 42. The VCSEL light source 42 has an array of diodes d₁, d₂, d₃, d₄ and d₅ each of which emits a light beam ℓ₁ ℓ₂, ℓ₃, ℓ₄ and ℓ₅ respectively. Diodes d₁, d₂, d₃, d₄ and d₅ are exposed through the surface N. A plate 62 is mounted on the surface N. Bumps 64 of the surface N detaches the surface N from the plate 62. Plate 62 has apertures 66 which allow the light beams ℓ₁, ℓ₂, ℓ₃, ℓ₄ and ℓ₅ to pass through the plate 62. Plate 62 also has an array of light detectors (light sensors) S₁, S₂, S₃, S₄ and S₅.

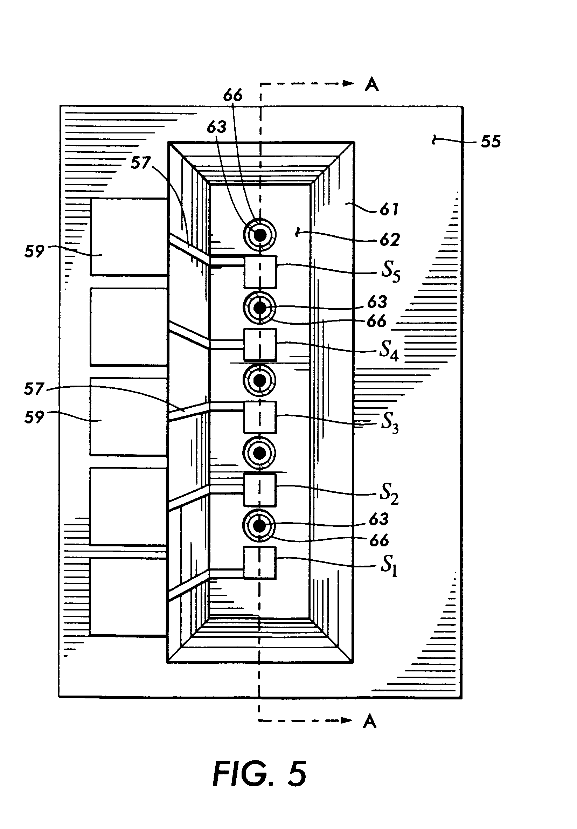

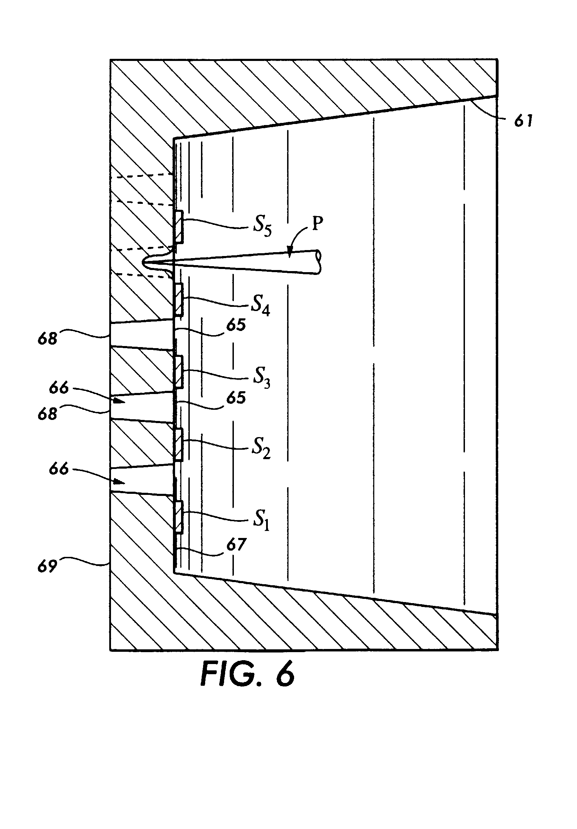

Referring to Figure 5, there is shown a magnified top view of the plate 62 and referring to Figure 6, there is shown a cross sectional view of the plate 62 along line A-A of Figure 5. Referring to both Figures 5 and 6, a plate 61 such as a silicon plate with a thickness, for instance 300µm, is etched to create a thin plate 62, for instance 30µm. After the plate 61 is etched, light detectors S₁, S₂, S₃, S₄, and S₅ are fabricated on plate 62 by well known micro electronics processes. The distance g (see Figure 4) between the centers C of each two adjacent light detectors (e.g. S₃ and S₄) is the same as the distance h between the centers C₁ of each two adjacent laser diodes (e.g. d₃ and d₄). The distance h between the diodes depends on the system design and on the function for which they are designed.

Referring to Figure 5, contacts 59 are located on surface 55. Contacts 59 provide connection to the circuitry (not shown) which control the light detector S₁, S₂, S₃, S₄, and S₅. The control circuitry also receive the generated signals from the light detectors S₁, S₂, S₃, S₄, and S₅. Lines 57 represent the connection between each light detector and its contact 59.

Referring to Figure 6, after the light detectors S₁, S₂, S₃, S₄, and S₅ are fabricated, the apertures 66 have to be created in the plate 62. In the preferred embodiment of this invention, a laser light beam is used to create apertures 66 one by one. By striking a laser light beam such as the laser light beam P onto the plate 62 on an area such as the area between the light detectors S₅ and S₄, an aperture 66 will be etched in the plate 62. Each aperture 66 is located between two adjacent light detectors.

It should be noted that the apertures 66 and the light detectors S₁, S₂, S₃, S₄ and S₅ can be created to be on one line, as shown in Figure 5, or can be created to be offset with respect to each other. However, regardless of being on one line or offset, they have to be created in such a manner to form a pattern which has alternating apertures and light detectors. Furthermore, the pattern of the apertures as a stand alone pattern has to match the pattern of laser diodes and the pattern of the light detectors as a stand alone pattern also has to match the pattern of the laser diodes.

Due to the nature of the etching process via laser light beam, the apertures 66 have a conical shape in which the opening 65 on the surface 67 is larger than the opening 68 on the surface 69. In this invention, the opening 68 is selected to be slightly smaller than the size of each laser diode d₁, d₂, d₃, d₄ and d₅ of Figure 4. However, the opening 68 has to be larger than the emitting area (shown as 63 in Figure 4) of each laser diode d₁, d₂, d₃, d₄ and d₅.

Once the apertures 66 are created, referring back to Figure 4, the plate 62 will be bonded to the VCSEL light source 42 which is a well known light source in the industry. The plate 62 will be bonded to the light source 42 by a well known method called flip chip bonding. Prior to bonding of the plate 62 to the light source 42, each aperture 66 has to be aligned with a corresponding one of the laser diodes d₁, d₂, d₃, d₄, and d₅. The bumps 64 are created through the bonding process.

It should be noted that any method which can create the apertures 66 can replace the laser light beam used in this invention and any method which can bond the plate 62 to the light source 42 can replace the flip chip bonding used in this invention.

Referring back to Figure 3, for the purpose of simplicity, only the light beams ℓ₁ and ℓ₅ from the laser diodes d₁ and d₅ are shown. The light beams ℓ₁ and ℓ₅ along with the other light beams which are not shown pass through the collimator 44 and cross each other on the image plane P₁ of the collimator 44.

It should be noted that when the light beams ℓ₁ and ℓ₅ and the other light beams cross each other on plane P₁, the central rays of all light beams ℓ₁ and ℓ₅ cross each other at point f₁ which is the focal point of the collimator 44.

A semi transparent and semi-reflective plate 70 is placed in the general area of plane P₁ in such a manner that it has an angle a with respect to the plane P₁. The image plane P1 is a plane which is orthogonal to the optical axis 51 of the raster scanning system 40. Plate 70 allows a portion of each light beam to pass through while reflecting the remaining portion of each light beam. In the preferred embodiment of this invention, plate 70 is selected to allow about 95% of the light beam to pass through. Plate 70 can be partially coated to clip the light beam in the same manner as the aperture 16 of Figure 2.

It should be noted that as an alternative, instead of coating the plate 70, a separate aperture can be placed in the raster scanning system 40 to clip the light beams.

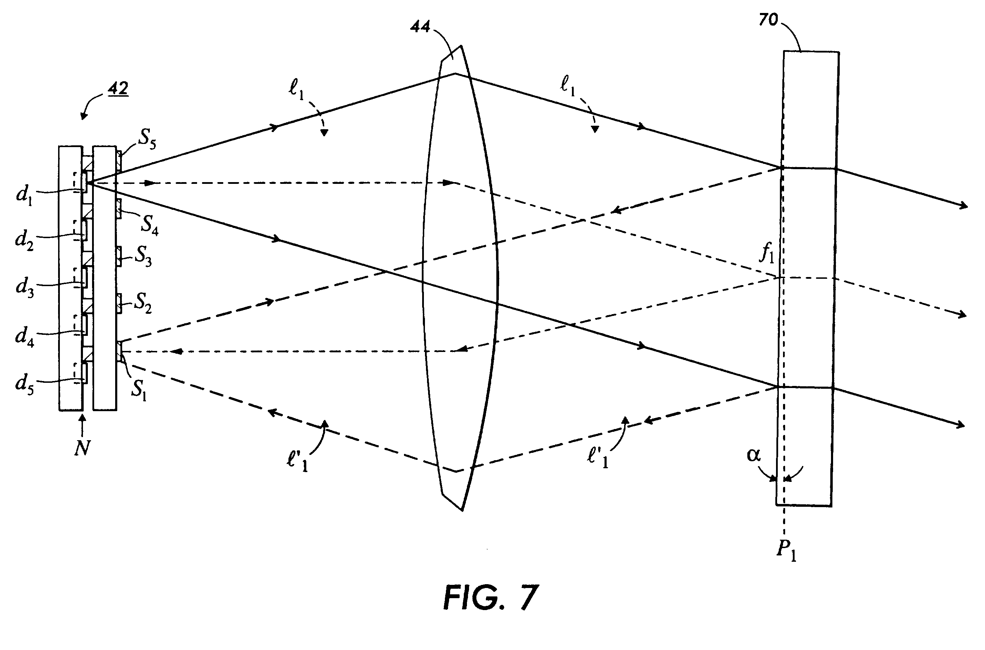

Referring to Figure 7, there is shown a magnified partial view of Figure 3 which shows the light source 42, the collimator 44 and the plate 70. Figure 7 shows only the path of the light beam ℓ₁ and the reflected light beam ℓ'₁. Once the light beam ℓ₁ from the laser diode d₁ strikes the plate 70, a portion of it will pass through the plate 70 and a portion of it will be reflected back as the light beam ℓ'₁. Due to the angle α of plate 70, the reflected light beam ℓ'₁ will be directed toward the light detector S₁. The reflected light beam ℓ'₁ will pass through the collimator 44 and focuses on the laser surface N. The detector S₁ is located in the path of the reflected light beam ℓ'₁. The detector S₁ receives the reflected light beam ℓ'₁ which is substantially focused.

Once the detector S₁, receives the reflected light beam ℓ'₁, it generates a signal which in a well known manner will be sent to a comparator to be compared with a reference level and the result will be used in a well known manner to modify the output power of the laser diode d₁.

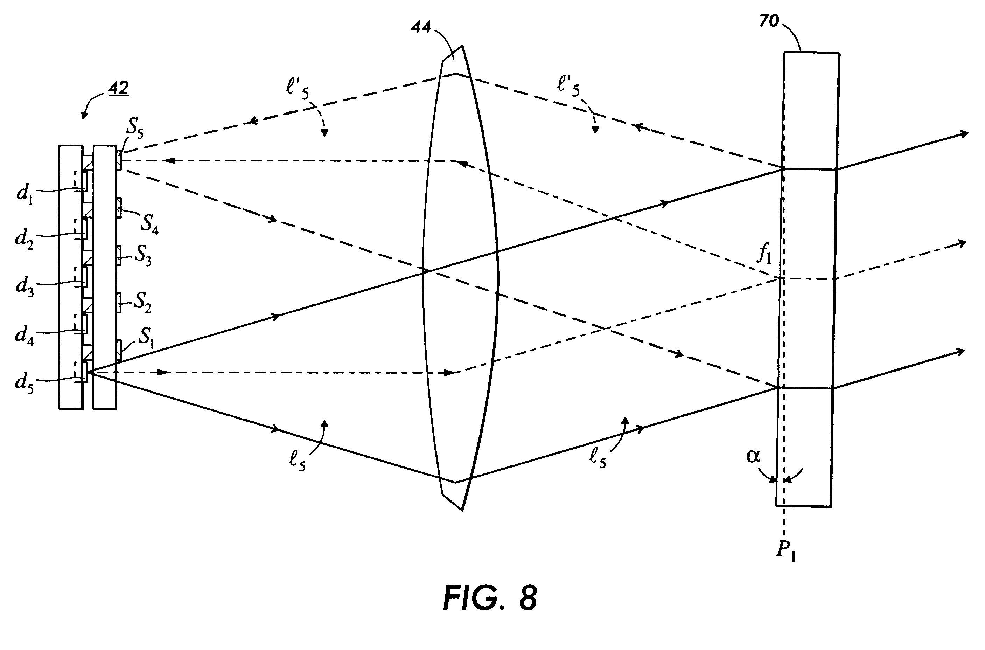

Referring to Figure 8, there is shown a magnified partial view of Figure 3 which shows the light source 42, the collimator 44 and the plate 70 with the light beam from the laser diode d₅. Figure 8 shows only the path of the light beam ℓ₅ and the reflected light beam ℓ'₅. Once the light beam ℓ₅ from the laser diode d₅ strikes the plate 70, a portion of it will pass through the plate 70 and a portion of it will be reflected back as the light beam ℓ'₅. The reflected light beam ℓ₅ passes through the collimator 44 and focuses on the plane N. Detector S₅ is located in the path of the reflected light beam ℓ'₅. Detector S₅ receives the substantially focused reflected light beam ℓ'₁ and generates a signal to modify the output power of the laser diode d₅.

In the same manner, there is one detector for the reflected light beam of each individual laser diode. Detectors S₂, S₃ and S₄ detect the light beam from the laser diodes d₂, d₃ and d₄ respectively.

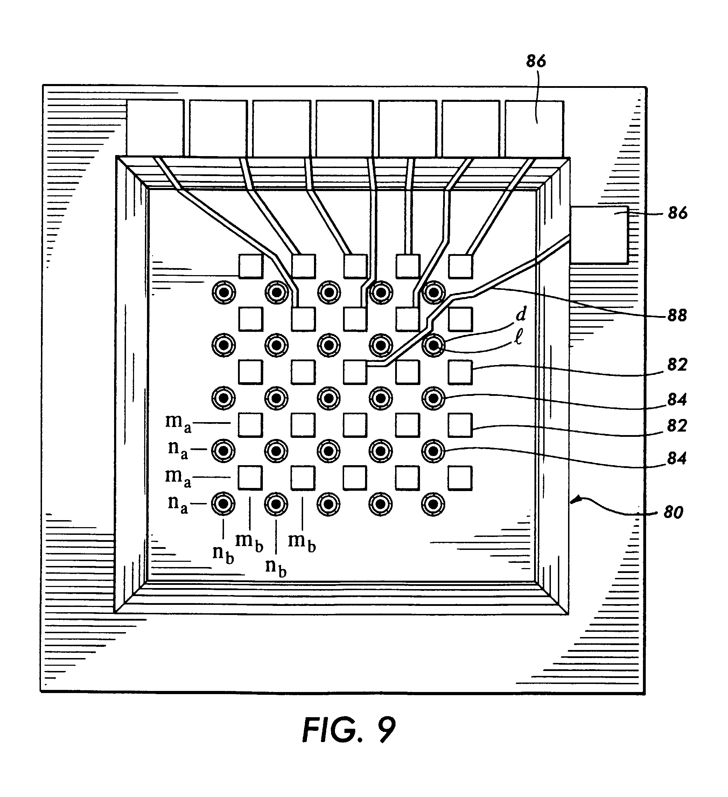

The light detectors of this invention can also be utilized for two dimensional arrays of VCSEL. Referring to Figure 9, there is shown a top view of a plate 80 which has a two dimensional array of light detectors 82. The plate 80 is bounded to a two dimensional array of VCSELs which is located under the plate 80. Each laser diode d of the VCSELs is under a corresponding aperture 84.

The light detectors 82 and the apertures 84 form a matrix and are located in an alternating manner. The light detectors 82 form rows nₐ and columns n_{b}. In the same manner, apertures 84 form rows mₐ and columns m_{b}. For the purpose of simplicity, only a limited number of rows and columns of the light detectors 82 and the apertures 84 are labeled. Columns n_{b} of light detectors and columns m_{b} of apertures are located in an alternating manner. Also, rows nₐ of light detecting means and rows mₐ of apertures are located in an alternating manner.

In Figure 9, the circles ℓ represent the light beam being generated by the laser diodes d which only a portion of them (white circles around the black circles) are visible through the apertures 84. Contacts 86 provide connection to the circuitry which control the light detectors 82 and receive the generated signals from the light detectors 82. Lines 88 represent the connection between each light detector 82 and its contact 86. For the purpose of simplicity, only a limited number of the contacts 86 and the connections 88 are shown.

It should further be noted that numerous changes in details of construction and the combination and arrangement of elements and materials may be resorted to without departing from the scope of the invention as hereinafter claimed.

## Claims

1. A raster output scanner (40) comprising:
a member (42) having a plurality of lasing diodes (d₁, d₂, d₃, d₄, d₅) for emitting a plurality of light beams (ℓ₁, ....., ℓ₅) and a plurality of light detecting means (S₁, S₂, S₃, S₄, S₅) each of which corresponds to one of said plurality of lasing diodes (d₁, d₂, d₃, d₄, d₅);
collimating means (44) located in the path of said plurality of light beams (ℓ₁, ....., ℓ₅) for collimating said light beams (ℓ₁, ....., ℓ₅);
a medium (54); and
scanning means (60) located in the path of said light beams (ℓ₁, ....., ℓ₅) from said collimating means (44) for scanning said light beams (ℓ₁, ....., ℓ₅) across said medium (54);
characterized in that the scanner (40) further comprises semi-transparent and semi-reflective means (70) located between said collimating means (44) and said scanning means (60) for receiving said light beams (ℓ₁, ....., ℓ₅) and partially passing said light beams (ℓ₁, ....., ℓ₅) onto said scanning means (60) and partially reflecting each of said light beams (ℓ'₁, ....., ℓ'₅) back onto one of said light detecting means (S₁, S₂, S₃, S₄, S₅) through said collimating means (44).

2. A scanner according to claim 1, further having an optical axis (51) and said semi-transparent and semi-reflective means (70) forms an angle (α) with a plane (P₁) which is orthogonal to said optical axis (51).
